# EUROPEAN PATENT APPLICATION

(11) **EP 2 833 706 A1**
(43) Date of publication of application: **04.02.2015**
(21) Application number: 13770197.5
(22) Date of filing: 13.03.2013
(51) Int. Cl.: H05K 7/20, F21V 31/00, F21V 31/03, H05K 5/06

(54) **VENTILATION SYSTEM**

(30) Priority: 30.03.2012 JP 2012079296; 10.09.2012 JP 2012198242
(71) Applicant: Nitto Denko Corporation, Osaka 567-8680 (JP)
(72) Inventor: YANO, Youzou, Ibaraki-shi Osaka 567-8680 (JP); TEZUKA, Teppei, Ibaraki-shi Osaka 567-8680 (JP); FURUUCHI, Kouji, Ibaraki-shi Osaka 567-8680 (JP)
(74) Representative: Intès, Didier Gérard André
(86) International application number: PCT/JP2013/001664
(87) International publication number: WO 2013/145604

(57) **Abstract**

A ventilation system 1 includes: a housing 2 having at least one pair of ventilation holes 21; and a piezoelectric blower 3 attached to at least one of the pair of ventilation holes 21. The piezoelectric blower 3 is operative to vibrate a diaphragm by a piezoelectric element so as to produce air circulation through the ventilation holes 21. With this configuration, it is possible to produce forced convection while saving space, since the piezoelectric blower 3 has the shape of a thin plate. In addition, since the piezoelectric blower 3 continuously operates while being supplied with electricity, moisture can be discharged from the interior of the housing 2 to the outside in a short time.

## Description

### TECHNICAL FIELD

The present invention relates to a ventilation system operative to ventilate the interior of a housing.

### BACKGROUND ART

In the case of automobile lamps, for example, conventional practice for preventing dew condensation of water in a housing containing electrical components is to provide the housing with a plurality of ventilation holes and to ventilate the interior of the housing by forced convection or natural convection using a fan or a wind generated by travel of a vehicle (see Patent Literature 1, for example).

### CITATION LIST

### Patent Literature

Patent Literature 1: JP 2011-519136 A

### SUMMARY OF INVENTION

### Technical Problem

However, when a fan is used, a large space for installing the fan is required, and when a wind generated by travel of a vehicle is used, it is only during the travel of the vehicle that moisture can be discharged from the interior of the housing to the outside. In addition, with the use of natural convection, discharge of moisture from the interior of the housing to the outside is insufficient.

In view of such circumstances, the present invention aims to provide a ventilation system capable of discharging moisture from the interior of a housing to the outside in a short time while saving space.

### Solution to Problem

In order to solve the above problems, a ventilation system of the present invention is characterized by including: a housing having at least one pair of ventilation holes; and a piezoelectric blower attached to at least one of the pair of ventilation holes and operative to vibrate a diaphragm by a piezoelectric element so as to produce air circulation through the ventilation holes.

### Advantageous Effects of Invention

With the above configuration, it is possible to produce forced convection while saving space, since the piezoelectric blower has the shape of a thin plate. In addition, since the piezoelectric blower continuously operates while being supplied with electricity, moisture can be discharged from the interior of the housing to the outside in a short time.

### BRIEF DESCRIPTION OF DRAWINGS

FIG. 1 is a configuration diagram of a ventilation system according to an embodiment of the present invention.
FIG. 2 is a configuration diagram of a ventilation system according to another embodiment.
FIG. 3 is a cross-sectional view of a piezoelectric blower used in the ventilation system of FIG. 1.
FIG. 4 is a cross-sectional view of a piezoelectric blower whose flow inlets are covered with a gas-permeable member.
FIG. 5 is a cross-sectional view of a piezoelectric blower whose flow outlet is covered with a gas-permeable member.
FIG. 6 is a cross-sectional view of a ventilation member.
FIG. 7 is a cross-sectional view of another ventilation member.

### DESCRIPTION OF EMBODIMENTS

Hereinafter, embodiments of the present invention will be described with reference to the accompanying drawings.

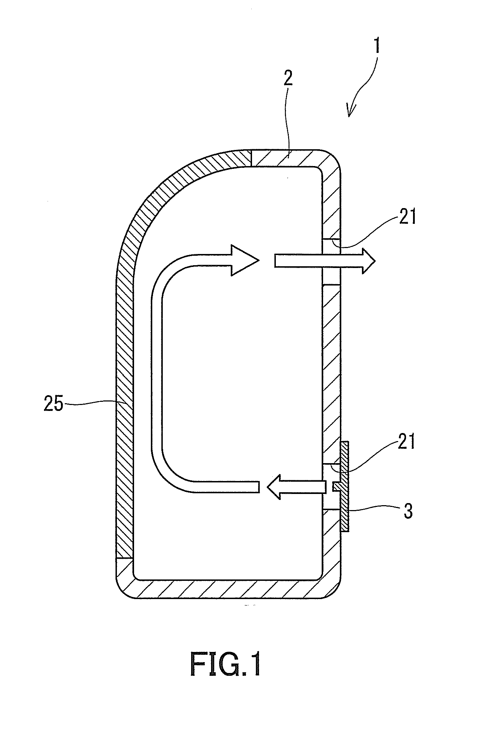

FIG. 1 shows a ventilation system 1 according to an embodiment of the present invention. This ventilation system 1 includes a housing 2 and a piezoelectric blower 3.

The housing 2 is, for example, a housing that contains electrical components. In the present embodiment, a portion of the housing 2 is formed of a transparent member 25 made of resin or glass. When the ventilation system 1 is applied, for example, to a lighting device such as an automobile lamp, the transparent member 25 allows transmission of light from a light source contained in the housing 2. The entire housing 2 may be formed of the transparent member 25. It is not always necessary for the housing 2 to include the transparent member; for example, when the ventilation system 1 is applied to an ECU (Electrical Control Unit) of an automobile, the housing may be generally formed of metal.

The housing 2 has at least one pair of ventilation holes 21. In the present embodiment, the pair of ventilation holes 21 are spaced from each other in an up-and-down direction. The lower ventilation hole 21 is used for intake, and the upper ventilation hole 21 is used for discharge. The piezoelectric blower 3 that produces air circulation through the ventilation holes 21 is attached to the lower ventilation hole 21 so as to cover the lower ventilation hole 21. In the present embodiment, the piezoelectric blower 3 delivers air into the housing 2 through the ventilation hole 21.

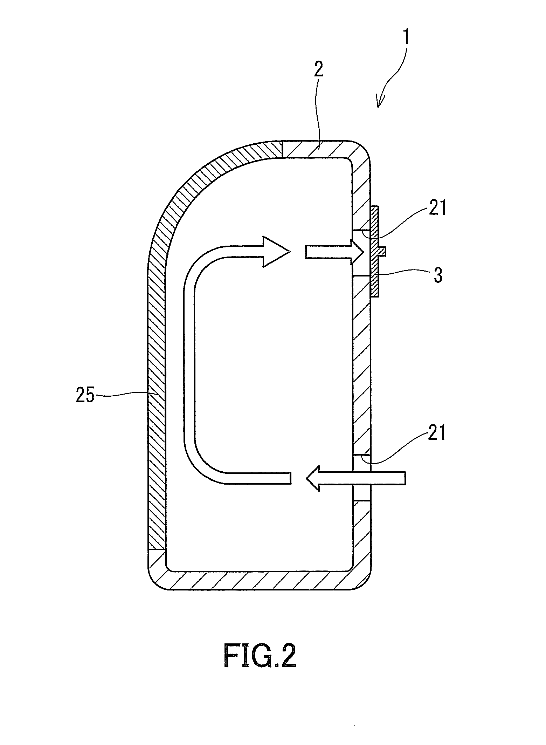

As shown in FIG. 2, the piezoelectric blower 3 may be attached to the upper ventilation hole 21 in a reverse orientation to that in FIG. 1. In this case, the piezoelectric blower 3 discharges air from the interior of the housing 2 to the outside through the ventilation hole 21. Alternatively, the piezoelectric blowers 3 may be attached to both of the ventilation holes 21. When the piezoelectric blowers 3 are attached to both of the ventilation holes 21, it is recommended to attach the piezoelectric blowers 3 in such a manner that air is supplied into the housing 2 through one of the ventilation holes 21 (see FIG. 1) and air is discharged outside the housing 2 through the other ventilation hole 21 (see FIG. 2).

The piezoelectric blower 3 has the shape of a thin plate that is flat in the direction in which the ventilation holes 21 open. The piezoelectric blower 3 draws in air around the piezoelectric blower 3 through a plurality of flow inlets 31, and discharges air through a central flow outlet 33. The direction in which the flow inlets 31 open need not be a direction opposite to the direction in which the flow outlet 33 opens, and may be a direction perpendicular to the direction in which the flow outlet 33 opens.

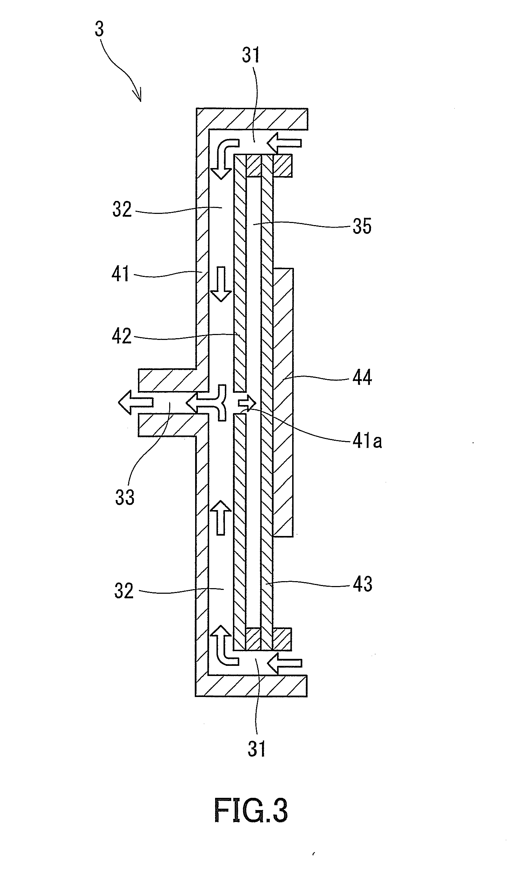

Specifically, as shown in FIG. 3, the piezoelectric blower 3 has: a principal wall 41 extending around a nozzle in which the flow outlet 33 is formed; an opposed wall 42 spaced from the principal wall 41; and a diaphragm 43 spaced from the opposed wall 42. FIG. 3 is a diagram cited from the homepage of Murata Manufacturing Co., Ltd. Between the principal wall 41 and the opposed wall 42 are formed flow paths 32 extending from each flow inlet 31 to the flow outlet 33. A pump chamber 35 is formed between the opposed wall 42 and the diaphragm 43. At the center of the opposed wall 42 is provided a blowing port 41a that is a through hole extending through the opposed wall 42. A piezoelectric element 44 is attached to the diaphragm 43. The piezoelectric element 44 vibrates the diaphragm 43 in the direction in which the blowing port 41a opens (the thickness direction of the opposed wall 42), so as to increase or decrease the volume of the pump chamber 35. When the volume of the pump chamber 35 is decreased, air is pushed out from the blowing port 41a toward the flow outlet 33. When the volume of the pump chamber 35 is increased, air flows into the pump chamber 35 through the blowing port 41a; however, most of the air flowing in the flow paths 32 continues to flow out of the flow outlet 33 by inertia.

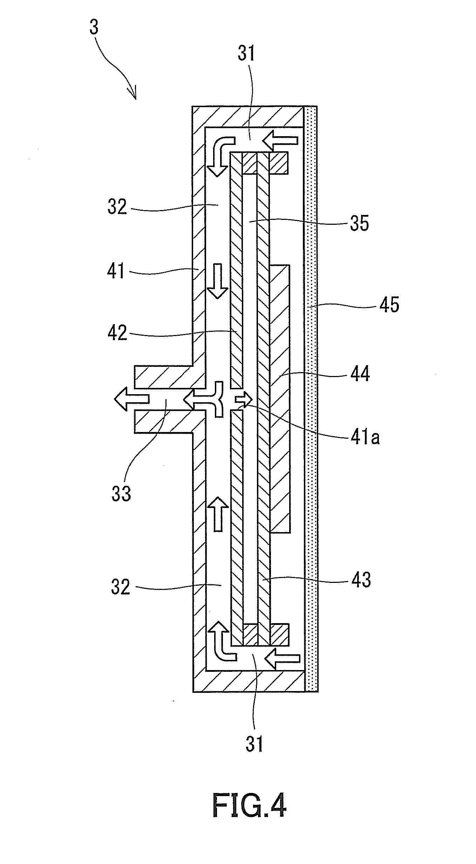

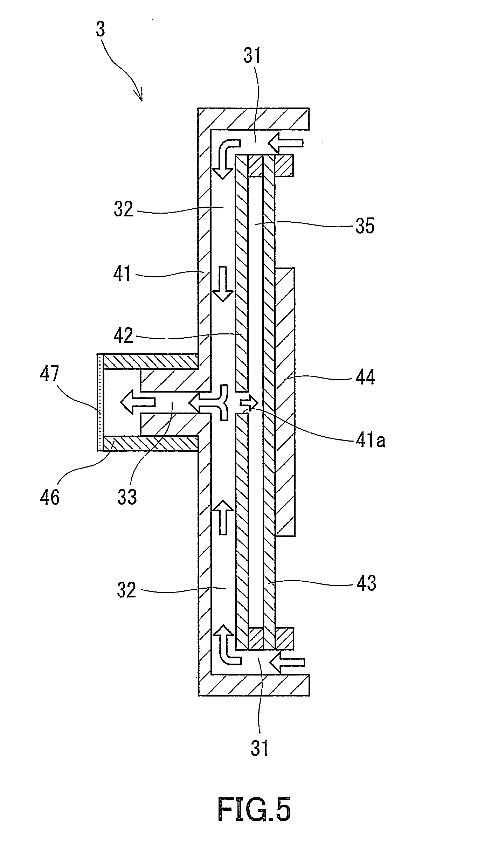

The flow inlets 31 may be covered with a gas-permeable member made of resin or metal, in order to prevent foreign matters such as water and dust from being drawn into the piezoelectric blower 3. As such a gas-permeable member, a woven fabric, a non-woven fabric, a mesh, a net, a sponge, a foam, a porous body, a water-proof gas-permeable membrane 6 described later, or the like, can be used. For example, as shown in FIG. 4, a single gas-permeable member 45 may be disposed on the suction side of the piezoelectric blower 3 so as to cover all of the flow inlets 31. Alternatively, as shown in FIG. 5, a gas-permeable support member 47 may be disposed on the discharge side of the piezoelectric blower 3 so as to cover the flow outlet 33. The gas-permeable support member 47 may be adhered to a front end face of the nozzle or may be held by a support 46 fitted on the nozzle.

Various methods can be used to attach the piezoelectric blower 3 to the ventilation hole 21. Examples of the methods include: joining to the housing 2 using a double-faced tape or an adhesive agent; and fixing to the housing 2 by a screw. Alternatively, when the principal wall 41 is made of resin or when another resin material is combined with the piezoelectric blower 3, ultrasonic welding, hot plate welding, press fitting into the ventilation hole 21, engagement (snap-fit) with the inner face of the housing 2 through the ventilation hole 21, or the like, may be employed.

The flow rate of air that the piezoelectric blower 3 can feed is, for example, 0.1 to 5 L/min at atmospheric pressure.

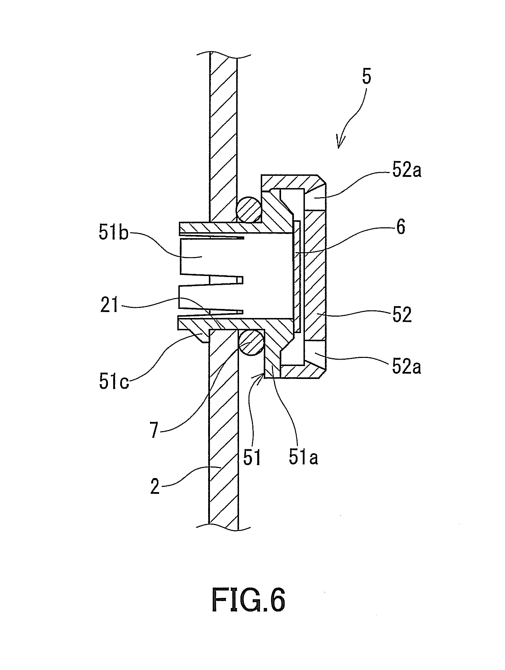

When the piezoelectric blower 3 is attached to one of the pair of ventilation holes 21, the other ventilation hole 21 may be left open; however, it is preferable that a ventilation member 5 operative to prevent entrance of foreign matters such as water and dust into the housing 2 be attached to the other ventilation hole 21 as shown in FIG. 6. The ventilation member 5 includes: a water-proof gas-permeable membrane 6; a support 51 supporting the water-proof gas-permeable membrane 6 and fixed to the housing 2; and a cover 52 covering the water-proof gas-permeable membrane 6.

The support 51 is generally in the shape of a tube, and has: a flange portion 51a to which the water-proof gas-permeable membrane 6 is adhered; and a tubular portion 51b projecting from the flange portion 51a and inserted in the ventilation hole 21 of the housing 2. Around the base of the tubular portion 51b is fitted a sealing member 7 that seals a gap between the ventilation member 5 and the housing 2. At the tip portion of the tubular portion 51b is formed a click portion 51c locked around the periphery of the ventilation hole 21 inside the housing 2. The cover 52 is provided with a through hole 52a for allowing the space surrounding the water-proof gas-permeable membrane 6 to open to the outside.

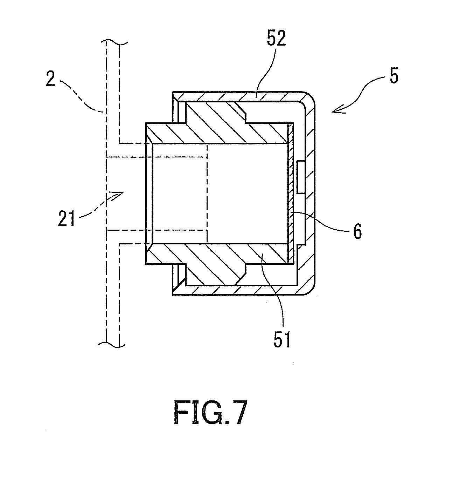

The configuration of the ventilation member 5 is not necessarily limited to that shown in FIG. 6, and various modifications are possible. For example, when a boss projects from the housing 2 so as to increase the length of the ventilation hole 21 as shown in FIG. 7, the support 51 may be configured to be fitted on the outer face of the boss. Furthermore, when a gap for ventilation is formed between an outer peripheral face of the support 51 and an inner peripheral face of the cover 52 as shown in FIG. 7, the water-proof gas-permeable membrane 6 can be omitted, since the ventilation path has a labyrinthine structure. In addition, the cover 52 can be omitted as appropriate.

The structure or the material of the water-proof gas-permeable membrane 6 is not particularly limited, as long as it is a membrane that permits permeation of gases and blocks permeation of liquids (a woven fabric, a non-woven fabric, a mesh, a net or the like made of resin or metal). For example, the water-proof gas-permeable membrane 6 may have a configuration in which a reinforcing layer is stacked on a porous resin membrane. By providing the reinforcing layer, the water-proof gas-permeable membrane 6 having high strength can be obtained.

A porous body of fluorine resin or a porous body of polyolefin that can be produced by a commonly-known stretching method or extraction method can be used as the material of the porous resin membrane. Examples of the fluorine resin include PTFE (polytetrafluoroethylene), polychlorotrifluoroethylene, tetrafluoroethylene-hexafluoropropylene copolymer, and tetrafluoroethylene-ethylene copolymer. Examples of the monomer constituting the polyolefin include ethylene, propylene, and 4-methylpentene-1,1-butene. A polyolefin obtained by polymerizing one of these monomers alone or by copolymerizing two or more of these monomers can be used. Alternatively, a porous body of a nanofiber film or the like using polyacrylonitrile, nylon, or polylactic acid can be used. Particularly preferred is a porous PTFE body that can ensure gas permeability with a small area and that has a high ability to block entrance of foreign matters into the housing.

The porous resin membrane may be subjected to liquid repellency-imparting treatment depending on the environment in which the housing 2 is used. The liquid repellency-imparting treatment can be performed by applying a material with small surface tension to the porous resin membrane, drying the material, and then curing the material. The liquid-repellent agent used in the liquid repellency-imparting treatment may be any agent by which a coating with surface tension lower than that of the porous resin membrane can be formed. For example, a liquid-repellent agent containing a polymer having a perfluoroalkyl group is suitable. The application of the liquid-repellent agent can be done by impregnation, spraying, or the like. The method for forming a coating using an oil-repellent agent containing a polymer having a perfluoroalkyl group is not particularly limited as long as a desired coating can be formed, and examples of the method include: coating with a solution or a dispersion of a polymer having a perfluoroalkyl group by air spraying, electrostatic spraying, dip coating, spin coating, roll coating (such as kiss coating and gravure coating), curtain flow coating, or impregnation; and a coating formation method using electrodeposition coating or plasma polymerization. In terms of ensuring sufficient waterproofness, it is desirable that the average pore diameter of the porous resin membrane be 0.01 µm or more and 10 µm or less.

It is preferable that a material having more excellent gas permeability than the porous resin membrane be used as the material of the reinforcing layer. Specifically, a woven fabric, a non-woven fabric, a mesh, a net, a sponge, a foam, a porous body or the like that is made of resin or metal can be used. Examples of the method for joining the porous resin membrane and the reinforcing layer together include adhesive lamination, thermal lamination, heat welding, ultrasonic welding, and bonding using an adhesive agent.

It is recommended that the thickness of the water-proof gas-permeable membrane 6 be adjusted, for example, in the range of 1 µm to 5 mm, in view of the strength and the ease of fixing to the support 51. When expressed in terms of Gurley number, the gas permeability of the water-proof gas-permeable membrane 6 is preferably more than 0 seconds/100 mL and 50 seconds/100 mL or less, and is more preferably more than 0 seconds/100 mL and 1 second/100 mL or less.

In the ventilation system 1 of the present embodiment described thus far, the piezoelectric blower 3 has the shape of a thin plate; therefore, it is possible to produce forced convection while saving space. In addition, since the piezoelectric blower 3 continuously operates while being supplied with electricity, moisture can be discharged from the interior of the housing 2 to the outside in a short time. For example, when the ventilation system 1 is applied to an automobile lamp, the interior of the housing 2 is forcibly ventilated simultaneously with the start-up of the engine of the automobile; thus, even when the transparent member 25 of which a portion of the housing 2 is formed is cloudy due to dew condensation of water, the cloudiness can be removed quickly.

### EXAMPLES

Hereinafter, the present invention will be described in detail with reference to examples. However, the present invention is not limited by these examples in any respect.

### (Example 1)

A housing 2 as shown in FIG. 1, which includes a transparent member 25 and is provided with a pair of ventilation holes 21, was prepared. The interior of the housing 2 had a volume of about 6000 cm³, and both of the ventilation holes 21 had a diameter of 5 mm. This housing 2 was set in a constant-temperature chamber with a temperature of 45°C and a humidity of 90% for 30 minutes.

Thereafter, a piezoelectric blower 3 was attached to the lower ventilation hole 21 of the housing 2. A microblower (drive frequency: about 26 kHz, discharge amount at atmospheric pressure: 1 L/min) manufactured by Murata Manufacturing Co., Ltd. was used as the piezoelectric blower 3. In this manner, a ventilation system was obtained.

### (Example 2)

A ventilation system was obtained in the same manner as in Example 1, except that a ventilation member 5 as shown in FIG. 6 was attached to the upper ventilation hole 21. The gas-permeability of the water-proof gas-permeable membrane 6 of the ventilation member 5 was 0.25 seconds/mL when expressed in terms of Gurley number.

### (Comparative Example)

A ventilation system was obtained in the same manner as in Example 1, except that the pair of ventilation holes 21 were left open (natural convection).

### <Test>

The transparent member 25 of each of the ventilation systems of Example 1, Example 2, and Comparative Example was sprinkled with 10°C pure water for 30 seconds. Thereafter, the piezoelectric blower 3 was powered on, and check for cloudiness was performed every 15 minutes. The results are shown in Table 1.

**[Table 1]**

| | Elapsed time | | | | | |
|---|---|---|---|---|---|---|
| | 0 minute | 15 minutes | 30 minutes | 45 minutes | 60 minutes | |
| Comparative Example | Poor | Poor | Poor | Poor | Good | Poor: Cloudiness was observed |
| Example 1 | Poor | Moderate | Good | Good | Good | Moderate: Slight cloudiness remained |
| Example 2 | Poor | Poor | Moderate | Good | Good | Good: No cloudiness was observed |

In Comparative Example using natural convection, a long time, 60 minutes, was required for removing cloudiness. By contrast, in Example 1 using forced convection, cloudiness was able to be removed in only 30 minutes. In Example 2 in which the ventilation member 5 was attached to the upper ventilation hole 21, cloudiness was able to be removed in 45 minutes.

## Claims

1. A ventilation system comprising:
a housing having at least one pair of ventilation holes; and
a piezoelectric blower attached to at least one of the pair of ventilation holes and operative to vibrate a diaphragm by a piezoelectric element so as to produce air circulation through the ventilation holes.

2. The ventilation system according to claim 1, wherein at least a portion of the housing is formed of a transparent member.

3. The ventilation system according to claim 1, wherein
the piezoelectric blower is attached to one of the pair of ventilation holes, and
a ventilation member operative to prevent entrance of water into the housing is attached to the other of the pair of ventilation holes.

4. The ventilation system according to claim 3, wherein the ventilation member comprises a water-proof gas-permeable membrane having a gas permeability that is 50 seconds/100 mL or less when expressed in terms of Gurley number.
